# FASCICULE DE BREVET EUROPEEN

(11) **EP 4 413 613 B1**
(45) Date de publication et mention de la délivrance du brevet: **15.10.2025**
(21) Numéro de dépôt: 22789278.3
(22) Date de dépôt: 21.09.2022
(51) Int. Cl.: H01L 21/18, H01L 21/02, H01L 21/762

(54) **PROCEDE DE FABRICATION D'UNE STRUCTURE COMPOSITE COMPRENANT UNE COUCHE MINCE EN SIC MONOCRISTALLIN SUR UN SUBSTRAT SUPPORT EN SIC POLY-CRISTALLIN**
VERFAHREN ZUR HERSTELLUNG EINER VERBUNDSTRUKTUR MIT EINER DÜNNSCHICHT AUS MONOKRISTALLINEM SIC AUF EINEM TRÄGERSUBSTRAT AUS POLYKRISTALLINEM SIC
METHOD FOR MANUFACTURING A COMPOSITE STRUCTURE COMPRISING A THIN FILM OF MONOCRYSTALLINE SIC ON A CARRIER SUBSTRATE OF POLYCRYSTALLINE SIC

(30) Priorité: 07.10.2021 FR 2110624; 07.10.2021 FR 2110626
(43) Date de publication de la demande: 14.08.2024
(73) Titulaire: SOITEC, 38190 Bernin (FR)
(72) Inventeur: BIARD, Hugo, 38190 Bernin (FR); RADU, Ionut, 38190 Bernin (FR); ALLIBERT, Frédéric, 38190 Bernin (FR)
(74) Mandataire: IP Trust
(86) Numéro de dépôt international: PCT/FR2022/051774
(87) Numéro de publication internationale: WO 2023/057700

(56) Documents cités:
- EP-A2- 0 755 068
- US-A1- 2005 151 155

## Description

### DOMAINE DE L'INVENTION

La présente invention concerne le domaine des matériaux semiconducteurs pour composants microélectroniques. Elle concerne en particulier un procédé de fabrication d'une structure composite comprenant une couche mince en carbure de silicium monocristallin sur un substrat support en carbure de silicium poly-cristallin.

### ARRIERE PLAN TECHNOLOGIQUE DE L'INVENTION

Le SiC est de plus en plus largement utilisé pour la fabrication de dispositifs de puissance innovants, pour répondre aux besoins de domaines montants de l'électronique, comme notamment les véhicules électriques.

Les dispositifs de puissance et les systèmes intégrés d'alimentation basés sur du carbure de silicium monocristallin peuvent gérer une densité de puissance beaucoup plus élevée par rapport à leurs homologues traditionnels en silicium, et ce avec des dimensions de zone active inférieures. Pour limiter encore les dimensions des dispositifs de puissance sur SiC, il est avantageux de fabriquer des composants verticaux plutôt que latéraux. Pour cela, une conduction électrique verticale, entre une électrode disposée en face avant de la structure SiC et une électrode disposée en face arrière, doit être autorisée par ladite structure.

Les substrats en SiC monocristallin (c-SiC) de haute qualité, destinés à l'industrie microélectronique, restent néanmoins chers et difficiles à approvisionner en grande taille. Il est donc avantageux de recourir à des solutions de transfert de couches, pour élaborer des structures composites comprenant typiquement une couche mince en SiC monocristallin (issue du substrat en c-SiC de haute qualité) sur un substrat support plus bas coût, par exemple en SiC poly-cristallin (p-SiC).

Une solution de transfert de couche mince bien connue est le procédé Smart Cut^{®}, (voir le document US 2017/330747) mettant en œuvre une implantation d'ions légers dans un substrat donneur monocristallin, et un assemblage, par collage direct, au niveau d'une interface de collage, sur un substrat support. Le transfert sur le substrat support de la couche mince, issue du substrat donneur, se fait grâce à une fracture le long d'un plan fragile enterré généré par l'implantation d'ions légers.

Une autre solution de transfert connue, en particulier pour les substrats silicium, est le procédé Eltran^{®}, qui implique une couche poreuse sur laquelle est crue par épitaxie la couche mince monocristalline, et un assemblage par collage direct sur le substrat support. Le transfert sur le substrat support de la couche mince se fait grâce à une séparation dans la couche poreuse. La séparation par une couche poreuse est connue du document DE102007021991.

### OBJET DE L'INVENTION

La présente invention concerne une solution alternative à celles de l'état de la technique. Elle concerne un procédé de fabrication d'une structure composite comprenant une couche mince en SiC monocristallin disposée sur un substrat support en SiC poly-cristallin. Elle concerne également une structure intermédiaire obtenue au cours dudit procédé de fabrication.

### BREVE DESCRIPTION DE L'INVENTION

L'invention concerne un procédé de fabrication d'une structure composite comprenant une couche mince en carbure de silicium monocristallin disposée sur un substrat support en carbure de silicium poly-cristallin, le procédé comprenant :
a) une étape de fourniture d'un substrat initial en carbure de silicium monocristallin, présentant une face avant et une face arrière, et d'un substrat support en carbure de silicium poly-cristallin présentant une face avant et une face arrière,
b) une étape de porosification appliquée au substrat initial, pour former une couche poreuse au moins du côté de la face avant du substrat initial,
c) une étape de formation d'une couche superficielle en carbure de silicium amorphe, sur la face avant du substrat support et/ou sur la couche poreuse,
d) une étape d'assemblage du substrat initial et du substrat support au niveau de leurs faces avant respectives, menant à l'obtention d'une première structure intermédiaire,
e) une étape de traitement thermique appliqué à la première structure intermédiaire, à une température supérieure à 900°C, pour cristalliser la couche superficielle, au moins en partie sous forme de carbure de silicium monocristallin, à partir d'une interface de contact avec la couche poreuse, pour former la couche mince, l'étape e) menant à l'obtention d'une deuxième structure intermédiaire,
f) une étape de séparation dans la couche poreuse de la deuxième structure intermédiaire, pour obtenir d'une part la structure composite et d'autre part le reste du substrat initial.

Selon d'autres caractéristiques avantageuses et non limitatives de l'invention, prises seules ou selon toute combinaison techniquement réalisable :
- à l'issue de l'étape b), la couche poreuse présente une épaisseur comprise entre 0,5µm et 5µm ;
- à l'issue de l'étape b), la couche poreuse comprend des pores dont la taille est comprise entre 1nm et 50nm, et présente un taux de porosification compris entre 10% et 70% ;
- à l'issue de l'étape c), la couche superficielle présente une épaisseur inférieure ou égale à 10µm ;
- à l'issue de l'étape c), la couche superficielle présente une épaisseur inférieure ou égale à 1µm, typiquement de l'ordre de cent à quelques centaines de nanomètres ;
- l'étape c) comprend le dépôt d'une couche en carbure de silicium amorphe, au moins du côté de la face avant du substrat support et/ou au moins sur la couche poreuse, pour former la (ou les) couche(s) superficielle(s) ;
- la couche en carbure de silicium amorphe déposée est fortement dopée et présente une concentration en espèces dopantes supérieure à 10¹⁹/cm³, voire supérieure à 10²⁰/cm³ ;
- l'étape c) comprend une amorphisation d'une couche de surface du substrat support, au moins du côté de sa face avant, pour former la couche superficielle ;
- l'étape d) comprend, préalablement à l'assemblage du substrat initial et du substrat support, la formation d'une couche de collage sur l'un et/ou l'autre des substrats, du côté de leurs faces avant respectives, la couche de collage présentant, après assemblage, une épaisseur totale inférieure ou égale à 10nm ;
- la couche de collage est composée d'au moins un matériau choisi parmi le silicium, le nickel, le titane et le tungstène ;
- au cours de l'étape e), une segmentation sous forme de nodule ou une dissolution de la couche de collage autorise un contact direct, au moins localement, entre la couche superficielle et la couche poreuse ou entre la couche superficielle et le substrat support ;
- le traitement thermique de l'étape e) est effectué à une température supérieure ou égale à 1000°C, préférentiellement supérieure ou égale à 1400°C, voire supérieure ou égale à 1850°C ;
- à l'étape e), la cristallisation de la couche superficielle s'opère au moins en partie sous forme de carbure de silicium poly-cristallin, à partir d'une interface de contact avec le substrat support, pour former une couche intermédiaire ;
- le procédé de fabrication comprend après l'étape f), une étape g) de finition comprenant des traitement(s) mécanique(s) et/ou chimique(s) de la structure composite, pour éliminer des résidus de couche poreuse de la face avant de la couche mince et/ou pour corriger l'uniformité d'épaisseur de la structure composite ;
- l'étape g) comprend un traitement thermique, appliqué à la structure composite, à une température comprise entre 1000°C et 1900°C, avant ou après les traitements mécanique(s) et/ou chimique(s) ;
- le procédé de fabrication comprend une étape de reconditionnement du reste du substrat initial en vue d'une réutilisation en tant que substrat initial pour la fabrication d'une nouvelle structure composite.

L'invention concerne également une structure intermédiaire comprenant :
- un substrat support en carbure de silicium poly-cristallin,
- au moins une couche superficielle en carbure de silicium amorphe, disposée sur le substrat support, du côté de sa face avant,
- une couche poreuse disposée sur la couche superficielle,
- un substrat initial en carbure de silicium monocristallin sur la couche poreuse
   - la couche poreuse étant disposée directement en contact ou via une couche de collage sur la couche superficielle, une interface de collage étant présente entre la couche poreuse et la couche superficielle, ou
   - la couche superficielle étant disposée directement en contact ou via une couche de collage, sur le substrat support, une interface de collage étant présente entre le substrat support et la couche superficielle, ou
   - une couche superficielle du côté de la couche poreuse étant disposée directement en contact ou via une couche de collage sur une autre couche superficielle du côté du substrat support, une interface de collage étant présente entre les deux couches superficielles.

### BREVE DESCRIPTION DES FIGURES

D'autres caractéristiques et avantages de l'invention ressortiront de la description détaillée de l'invention qui va suivre en référence aux figures annexées sur lesquelles :

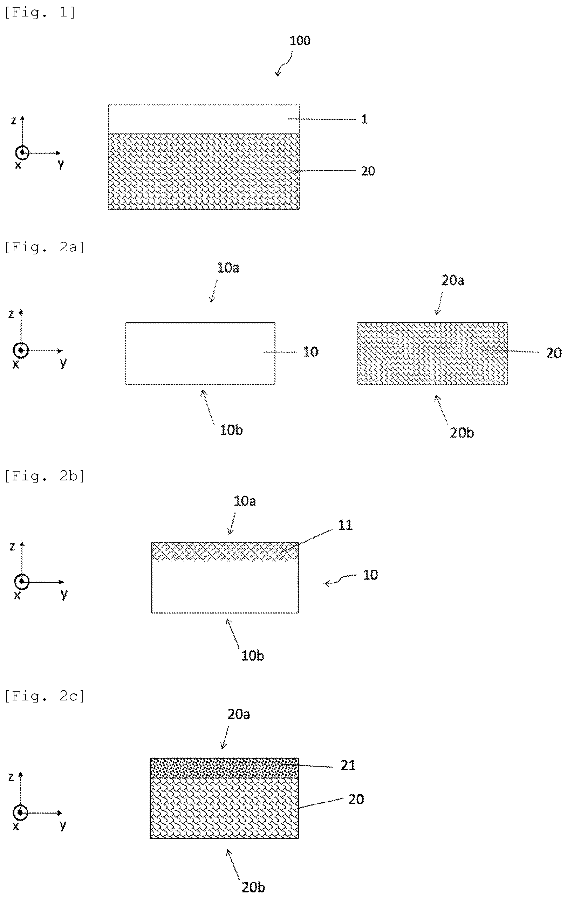

[Fig. 1] La figure 1 présente une structure composite élaborée selon un procédé de fabrication conforme à l'invention ;
[Fig. 2a]
[Fig. 2b]
[Fig. 2c]
[Fig. 2c']
[Fig. 2d]
[Fig. 2d']
[Fig. 2d"]
[Fig. 2e]
[Fig. 2f]

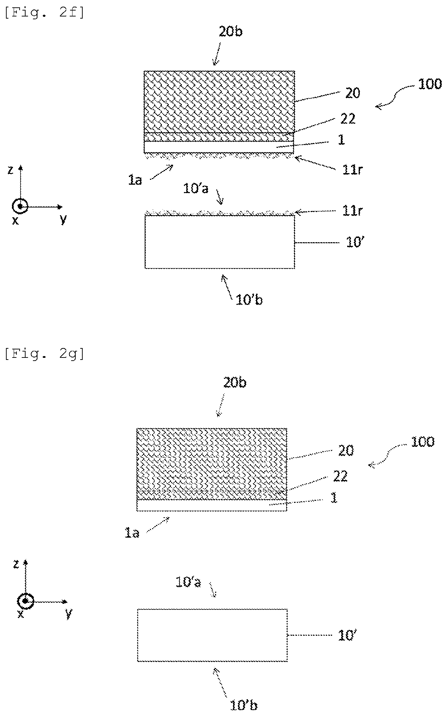

[Fig. 2g] Les figures 2a à 2g présentent des étapes d'un procédé de fabrication conforme à l'invention.

Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

### DESCRIPTION DETAILLEE DE L'INVENTION

La présente invention concerne un procédé de fabrication d'une structure composite 100 comprenant une couche mince 1 en carbure de silicium monocristallin (c-SiC sera utilisé par la suite pour parler de carbure de silicium monocristallin) disposée sur un substrat support 20 en carbure de silicium (figure 1). Le substrat support 20 est poly-cristallin (p-SiC).

Le procédé comprend en premier lieu une étape a) de fourniture d'un substrat initial 10 en carbure de silicium monocristallin (figure 2a). Le substrat initial 10 se présente préférentiellement sous la forme d'une plaquette de diamètre 100mm, 150mm, 200mm voire 300mm et d'épaisseur comprise typiquement entre 300 et 800 microns. Il présente une face avant 10a et une face arrière 10b. La rugosité de surface de la face avant 10a est avantageusement choisie inférieure à 1nm Ra (rugosité moyenne) mesurée par microscopie à force atomique (AFM), par exemple sur un scan de 20 microns x 20 microns. Le substrat initial 10 peut être de polytype 4H ou 6H, et présenter un dopage de type n ou p.

L'étape a) comprend également la fourniture d'un substrat support 20 en carbure de silicium poly-cristallin présentant une face avant 20a et une face arrière 20b (figure 2a).

Le substrat support 20 peut être élaboré par une technique classique telle que le frittage ou le dépôt chimique en phase vapeur. Il se présente préférentiellement sous une forme identique à celle du substrat initial 10, typiquement sous forme de plaquette de diamètre et d'épaisseur typiques mentionnés cidessus en référence au substrat initial 10. La rugosité de surface de la face avant 20a du substrat support 20 est avantageusement choisie inférieure à 1nm Ra, au moins lorsque cette face est destinée à être directement assemblée à une étape d) ultérieure du procédé.

Le procédé comprend ensuite une étape b) de porosification appliquée au substrat initial 10, pour former une couche poreuse 11 (figure 2b). Les méthodes connues de porosification du SiC, dont certaines sont décrites ou référencées dans les publications de Y. Shishkin et al (« Phoroelectrochemical etching of n-type 4H silicon carbide », Journal of Applied Physics 96, 2311, 2004) et de Gautier et al (« Electrochemical formation of porous silicon carbide for micro-device applications », Materials science forum, ISSN : 1662-9752, Vol.924, pages 943-946, 2018) pourront être appliquées au substrat initial 10 pour former la couche poreuse 11.

Avantageusement, la couche poreuse 11 présente une épaisseur comprise entre 0,5µm et 5µm ; le taux de porosification est préférentiellement compris entre 10% et 70%, et la taille des pores est comprise typiquement entre 1 nm et 50 nm.

Ces caractéristiques sont favorables, d'une part à la cristallisation au contact de la couche poreuse 11 (étape e) suivante du procédé) d'une couche 21 en carbure de silicium amorphe sous forme monocristalline, laquelle couche est destinée à former la couche mince 1 de la structure composite 100 ; d'autre part, les caractéristiques de la couche poreuse 11 sont adaptées pour autoriser et faciliter la séparation au sein de cette couche, à une étape f) du procédé, tout en procurant une tenue mécanique suffisante au cours des étapes antérieures.

L'étape c) suivante du procédé de fabrication selon l'invention correspond à la formation d'une couche superficielle 21,12 en carbure de silicium amorphe, au moins sur la face avant 20a,10a du substrat support 20 ou du substrat initial 10.

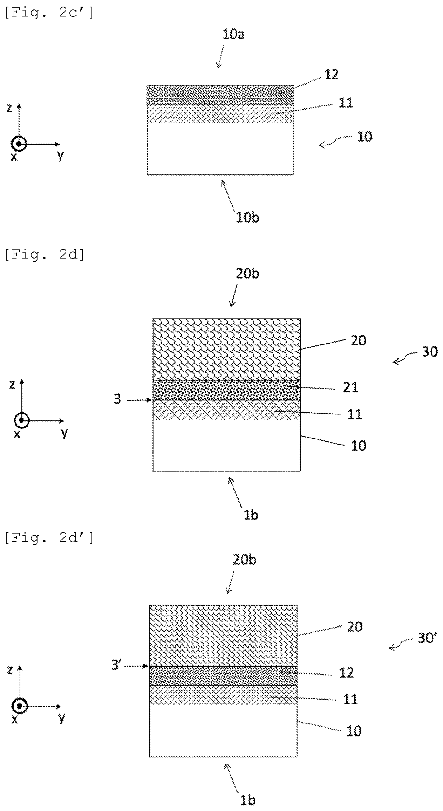

Selon un premier mode de réalisation, c'est le substrat 20 qui est muni au moins sur sa face avant 20a de ladite couche superficielle 21 en carbure de silicium amorphe (a-SiC) (figure 2c).

Selon un deuxième mode de réalisation, la couche superficielle 12 en carbure de silicium amorphe est formée sur au moins la face avant 10a du substrat initial 10, à savoir sur la couche poreuse 11 (figure 2c').

Selon un troisième mode de réalisation, une couche superficielle 21 est formée sur la face avant 20a du substrat support 20 et une autre couche superficielle 12 est formée sur la couche poreuse 11, elle-même disposée sur le substrat initial 10.

Dans l'un ou l'autre des modes de réalisation précités, la couche superficielle 21,12 pourra également être formée au niveau de la face arrière 20b,10b du ou des substrats concernés 20,10.

Quel que soit le mode de réalisation, la couche superficielle 21,12 présente avantageusement une épaisseur totale inférieure ou égale à 10µm.

Pour former cette couche superficielle 21,12, l'étape c) comprend, selon une première variante, le dépôt d'une couche en a-SiC sur le substrat concerné 20,10. Le dépôt de SiC amorphe peut être effectué par une technique de dépôt chimique en phase vapeur (CVD), par exemple, assisté par plasma (PECVD), ou assisté par injection liquide directe (DLI-CVD), par une technique de dépôt physique en phase vapeur, ou par toute autre technique connue. Dans le cas d'un dépôt CVD, on préfèrera une température de dépôt inférieure à 1100°C, voire inférieure à 1000°C ; concernant les précurseurs de dépôt (chimie de type méthane ou silane), le ratio C/Si sera préférentiellement choisi supérieur ou égale à 1.

Les techniques de dépôt mentionnées permettent de former une couche superficielle 21,12 dont l'épaisseur peut typiquement varier entre 100nm et 10µm, par exemple autour de 1µm. De même, le dopage de la couche superficielle 21,12 en a-SiC peut être ajusté aisément lorsqu'elle est formée par l'une de ces techniques. Elle peut notamment être fortement dopée (de type N, habituellement, mais éventuellement de type P) : pour cela, elle comprend des espèces dopantes dans une concentration supérieure à 10¹⁹/cm³, voire supérieure à 10²⁰/cm³. Rappelons que la couche superficielle 21,12 est destinée à être cristallisée, au moins partiellement, sous forme monocristalline, pour former la couche mince 1 de la structure composite 100 ; ainsi donc, elle peut être fortement dopée pour donner lieu à une couche mince 1 présentant une faible résistivité, selon les besoins de l'application visée.

Selon une deuxième variante, l'étape c) comprend l'amorphisation d'une couche de surface du substrat concerné, pour former la couche superficielle 21,12 en a-SiC. Cette amorphisation peut être réalisée par une technique connue, telle que par bombardement d'ions (par exemple Si ou C) ou de neutrons, avec des énergies appropriées pour former une couche amorphe 21,12 à l'épaisseur souhaitée.

Dans le cas d'une amorphisation d'une couche de surface du substrat support 20 (premier mode et troisième mode de réalisation), la structure poly-cristalline du substrat support 20 peut être rendue amorphe par exemple par bombardement d'ions. Selon cette deuxième variante de formation de la couche superficielle 21,12, l'épaisseur de cette dernière est préférentiellement inférieure à 1µm, typiquement de l'ordre de cent à quelques centaines de nanomètres.

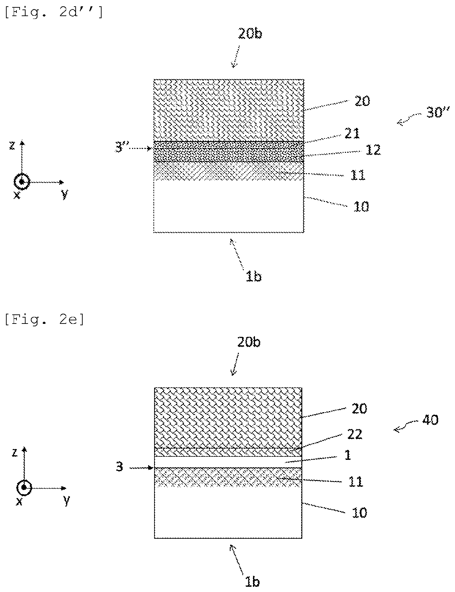

Le procédé de fabrication selon l'invention comprend ensuite une étape d) mettant en œuvre l'assemblage du substrat initial 10 et du substrat support 20 au niveau de leurs faces avant respectives 10a,20a (figure 2d, figure 2d', figure 2d").

Dans le premier mode de réalisation (figure 2d), la couche poreuse 11 et la couche superficielle 21 se retrouvent ainsi assemblées le long d'une interface de collage 3, menant à l'obtention d'une première structure intermédiaire 30.

Dans le deuxième mode de réalisation (figure 2d'), la couche superficielle 12 se trouve assemblée au substrat support 20, le long d'une interface de collage 3', menant à l'obtention d'une première structure intermédiaire 30'.

Enfin, dans le troisième mode de réalisation (figure 2d"), les couches superficielles 22,12 respectivement formées sur le substrat support 20 et la couche poreuse 11 sont assemblées le long d'une interface de collage 3", menant à l'obtention d'une première structure intermédiaire 30".

Comme nous le préciserons plus loin, quel que soit le mode de réalisation, l'interface de collage 3,3',3'', à l'étape d), peut impliquer un contact direct entre ou un contact indirect entre les surfaces assemblées, via une couche de collage.

L'assemblage de l'étape d) est basé sur un collage direct par adhésion moléculaire. Comme cela est bien connu en soi, un tel collage ne nécessite pas une matière adhésive, car des liaisons s'établissent à l'échelle atomique entre les surfaces assemblées. Plusieurs types de collage par adhésion moléculaire existent, qui diffèrent notamment par leurs conditions de température, de pression, d'atmosphère ou de traitements préalables à la mise en contact des surfaces. On peut citer le collage à température ambiante avec ou sans activation préalable par plasma des surfaces à assembler, le collage par diffusion atomique (« Atomic diffusion bonding » ou ADB selon la terminologie anglo-saxonne), le collage avec activation de surface (« Surface-activated bonding » ou SAB), etc.

L'étape d) d'assemblage peut comprendre, préalablement à la mise en contact des faces à assembler, des séquences classiques de nettoyages par voie chimique (par exemple, nettoyage RCA), d'activation de surface (par exemple, par plasma oxygène ou azote) ou autres préparations de surface (telles que le nettoyage par brossage (« scrubbing »)), susceptibles de favoriser la qualité de l'interface de collage 3,3',3" (faible défectivité, forte énergie d'adhésion).

Comme évoqué précédemment et de manière optionnelle, l'étape d) peut comprendre, préalablement à la mise en contact des faces à assembler des substrats 20,10, la formation d'une couche de collage sur l'une et/ou l'autre desdites faces. La couche de collage peut donc être déposée (par exemple par dépôt chimique en phase vapeur CVD) sur la couche poreuse 11 et/ou sur la couche superficielle 21 (dans le premier mode de réalisation), directement sur le substrat support 20 et/ou sur la couche superficielle 12 (dans le deuxième mode de réalisation) ou encore sur l'une et/ou l'autre des couches superficielles 22,12 (dans le troisième mode de réalisation).

La couche de collage peut être composée d'au moins un matériau choisi parmi le silicium, le nickel, le titane, le tungstène, etc. Elle est préférentiellement d'épaisseur réduite, typiquement son épaisseur totale est inférieure ou égale à 10nm, voire inférieure ou égale à 5nm. Dans le premier mode de réalisation, il est capital que la couche de collage présente une épaisseur faible permettant sa segmentation sous forme de nodules ou sa dissolution au cours du traitement thermique de l'étape e) ultérieure : cela procure alors un contact direct, au moins localement, entre la couche poreuse 11 et la couche superficielle 21 : ce contact direct est indispensable au bon déroulement de la cristallisation intervenant à l'étape e) suivante. Si la couche de collage est en matériau semi-conducteur (tel que le silicium notamment), elle pourra être dopée de manière à favoriser la conduction électrique verticale.

Comme illustré sur la figure 2d, la première structure intermédiaire 30 résultant de l'étape d), dans le premier mode de réalisation de l'invention, comprend, en partant du substrat support 20, et donc dans un ordre inverse à celui visible sur la figure :
- un substrat support 20 en carbure de silicium poly-cristallin avec une face arrière 20b,
- une couche superficielle 21 en carbure de silicium amorphe, sur le substrat support 20, du côté de sa face avant 20a,
- une couche poreuse 11 disposée, directement en contact ou via une couche de collage, sur la couche superficielle 21, une interface de collage 3 étant présente entre la couche poreuse 11 et la couche superficielle 21,
- un substrat initial 10 en carbure de silicium monocristallin sur et en contact avec la couche poreuse 11.

La figure 2d' illustre la première structure intermédiaire 30' résultant de l'étape d), dans le deuxième mode de réalisation de l'invention ; elle comprend :
- un substrat support 20 en carbure de silicium poly-cristallin,
- une couche superficielle 12 en carbure de silicium amorphe, disposée, directement en contact ou via une couche de collage, sur le substrat support 20, du côté de sa face avant 20a, une interface de collage 3' étant présente entre le substrat support 20 et la couche superficielle 12,
- une couche poreuse 11 sur la couche superficielle 12,
- un substrat initial 10 en carbure de silicium monocristallin sur et en contact avec la couche poreuse 11.

Enfin, la figure 2d" illustre la première structure intermédiaire 30" résultant de l'étape d), dans le troisième mode de réalisation de l'invention ; elle comprend :
- un substrat support 20 en carbure de silicium poly-cristallin,
- une couche superficielle 21 en carbure de silicium amorphe, sur le substrat support 20, du côté de sa face avant 20a,
- une autre couche superficielle 12 en carbure de silicium amorphe, disposée, directement en contact ou via une couche de collage, sur la couche superficielle 21, une interface de collage 3'' étant présente entre les deux couches superficielles 21,12,
- une couche poreuse 11 sur la couche superficielle 12,
- un substrat initial 10 en carbure de silicium monocristallin sur et en contact avec la couche poreuse 11.

L'étape e) suivante du procédé de fabrication implique un traitement thermique appliqué à la première structure intermédiaire 30,30',30'', à une température supérieure à 900°C, pour cristalliser la couche superficielle 21,12 (figure 2e). La température du traitement thermique est avantageusement supérieure ou égale à 1000°C, voire supérieure ou égale à 1400°C, voire encore supérieure ou égale à 1850°C. A titre d'exemple, pour une couche superficielle 21,12 en a-SiC de 1µm, un traitement thermique à 1700°C pendant 30min peut être appliqué. La couche superficielle 21,12 cristallise, par un phénomène d'épitaxie en phase solide, sous forme de carbure de silicium monocristallin, à partir d'une interface de contact direct entre la couche poreuse 11 (dont le SiC présente une structure monocristalline) et la couche superficielle 21,12 en a-SiC. La couche superficielle cristallisée sous forme monocristalline forme la couche mince 1.

Il se peut que seule une partie de la couche superficielle 21,12 cristallise sous forme monocristalline. En effet, la cristallisation peut s'opérer au moins en partie sous forme de carbure de silicium poly-cristallin, à partir de l'interface de contact avec le substrat support 20 : une couche intermédiaire 22 est alors formée, prolongement en p-SiC du substrat support 20 jusqu'à la couche mince 1 en c-SiC. En d'autres termes, la couche intermédiaire 22 est interposée entre le substrat support 20 et la couche mince 1. L'interface entre la couche intermédiaire 22 et la couche mince 1 a l'avantage d'être parfaitement fermée car définie dans un même matériau a-Si (couche(s) superficielle(s) 21,12) par la rencontre des fronts de cristallisation c-SiC et p-SiC. C'est un avantage intéressant par rapport à une interface de collage entre deux matériaux de nature cristalline différente (p-SiC/c-SiC par exemple), dont la fermeture complète est notamment tributaire de la rugosité et de l'état de surface desdits matériaux avant assemblage.

Afin d'obtenir une telle couche intermédiaire 22, il est notamment prévu, si aucune couche superficielle 21 n'est présente sur le substrat support 20 (c'est-à-dire dans le deuxième mode de réalisation), que la couche superficielle 12 en a-Si (du côté de la couche poreuse 11) soit en contact direct avec le substrat support 20, en l'absence de couche de collage ou par l'utilisation d'une couche de collage discontinue, par exemple une couche de collage formant un ensemble de nodules entre lesquels le substrat support 20 est en contact direct avec la couche superficielle 12.

L'étape e) mène à l'obtention d'une deuxième structure intermédiaire 40, quel que soit le mode de réalisation implémenté, dans laquelle tout ou partie de la (ou des) couche(s) superficielle(s) 21,12 est cristallisé(e) sous forme monocristalline pour former la couche mince 1 (figure 2e).

Le procédé de fabrication comprend enfin une étape f) de séparation dans la couche poreuse 11 de la deuxième structure intermédiaire 40, pour obtenir d'une part, la structure composite 100, et d'autre part, le reste 10' du substrat initial (figure 2f).

L'étape f) de séparation est opérée par application d'une contrainte mécanique à la deuxième structure intermédiaire 40. La contrainte peut être exercée par l'appui et/ou l'insertion d'un outil (par exemple, une lame ou autre forme en biseau) au niveau du bord de ladite structure intermédiaire 40, en vis-à-vis de la couche poreuse 11. Alternativement, la contrainte mécanique peut être appliquée par jet d'eau ou d'air, orienté vers le bord de la structure 40, toujours en vis-à-vis de la couche poreuse 11. Quelle que soit la technique de séparation mise en œuvre, la contrainte mécanique appliquée doit être adaptée pour propager une onde de fracture dans la couche poreuse 11, laquelle est de moindre résistance mécanique par rapport aux autres couches ou interfaces dans la deuxième structure intermédiaire 40.

En prenant soin de protéger les faces libres de la deuxième structure intermédiaire 40, la séparation pourra éventuellement être favorisée par gravure chimique latérale de la couche poreuse 11.

A l'issue de l'étape f) de séparation, la face libre la de la couche mince 1 de la structure composite 100 peut présenter des résidus 11r de couche poreuse (figure 2f), de même que la face avant 10'a du reste 10' de substrat initial.

Le procédé selon l'invention peut donc comprendre une étape g) de traitement(s) mécanique(s) et/ou chimique(s) de la structure composite 100, pour éliminer des résidus 11r de couche poreuse 11 de la face avant la de la couche mince 1 et/ou pour corriger l'uniformité d'épaisseur de la structure composite 100 (figure 2g).

L'étape g) peut comprendre un polissage mécano-chimique (CMP) et/ou un traitement chimique ou plasma (gravure ou nettoyage) et/ou un traitement mécanique (rectification), pour retirer le résidu 11r.

L'étape g) peut également comprendre des nettoyages de type Caro (« piranha etch » selon la terminologie anglo-saxonne) et/ou SC1/SC2 (« Standard Clean 1 », « Standard Clean 2 ») et/ou HF (acide fluorhydrique), ou un plasma N2, Ar ou CF4, pour améliorer encore la qualité de la face libre la de la couche mince 1.

L'étape g) peut comprendre un traitement thermique, appliqué à la structure composite 100, à une température comprise entre 1000°C et 1900°C, pendant environ une heure et jusqu'à quelques heures. Ce traitement thermique peut être opéré avant ou après les traitements mécanique(s) et/ou chimique(s) précités. Son objectif est de stabiliser la structure composite 100, en faisant, le cas échéant, sensiblement évoluer la qualité cristalline de la couche mince 1, de sorte que la structure 100 soit parfaitement compatible avec des traitements thermiques ultérieurs à très hautes températures, requis pour la fabrication de composants sur et/ou dans ladite couche 1.

Enfin, le procédé de fabrication peut comprendre une étape de reconditionnement du reste 10' du substrat initial en vue d'une réutilisation en tant que substrat initial 10 pour une nouvelle structure composite 100 (figure 2g). Des traitements mécaniques et/ou chimiques, similaires à ceux appliqués à la structure composite 100 pour retirer le résidu 11r, peuvent être mis en œuvre au niveau de la face avant 10'a du substrat restant 10'. L'étape de reconditionnement peut également comprendre un ou plusieurs traitements des bords du substrat restant 10' et/ou de sa face arrière 10'b, par polissage mécano-chimique, par rectification mécanique, et/ou par gravure chimique sèche ou humide.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Procédé de fabrication d'une structure composite (100) comprenant une couche mince (1) en carbure de silicium monocristallin disposée sur un substrat support (20) en carbure de silicium poly-cristallin, le procédé comprenant:
**a)** une étape de fourniture d'un substrat initial (10) en carbure de silicium monocristallin, présentant une face avant (10a) et une face arrière (10b), et d'un substrat support (20) en carbure de silicium poly-cristallin présentant une face avant (20a) et une face arrière (20b),
**b)** une étape de porosification appliquée au substrat initial (1), pour former une couche poreuse (11) au moins du côté de la face avant (10a) du substrat initial (10),
**c)** une étape de formation d'une couche superficielle (21,12) en carbure de silicium amorphe, sur la face avant (20a) du substrat support (20) et/ou sur la couche poreuse (11),
**d)** une étape d'assemblage du substrat initial (10) et du substrat support (20) au niveau de leurs faces avant respectives, menant à l'obtention d'une première structure intermédiaire (30,30',30''),
**e)** une étape de traitement thermique appliqué à la première structure intermédiaire (30,30',30''), à une température supérieure à 900°C, pour cristalliser la couche superficielle (21,12), au moins en partie sous forme de carbure de silicium monocristallin, à partir d'une interface de contact avec la couche poreuse (11), pour former la couche mince (1), l'étape e) menant à l'obtention d'une deuxième structure intermédiaire (40),
**f)** une étape de séparation dans la couche poreuse (11) de la deuxième structure intermédiaire (40), pour obtenir d'une part la structure composite (100) et d'autre part le reste (10') du substrat initial.

2. Procédé de fabrication selon la revendication précédente, dans lequel, à l'issue de l'étape b), la couche poreuse (11) présente une épaisseur comprise entre 0,5µm et 5µm.

3. Procédé de fabrication selon l'une des revendications précédentes, dans lequel, à l'issue de l'étape b), la couche poreuse (11) comprend des pores dont la taille est comprise entre 1nm et 50nm, et présente un taux de porosification compris entre 10% et 70%.

4. Procédé de fabrication selon l'une des revendications précédentes, dans lequel, à l'issue de l'étape c), la couche superficielle (21,12) présente une épaisseur inférieure ou égale à 10µm.

5. Procédé de fabrication selon l'une des revendications précédentes, dans lequel, à l'issue de l'étape c), la couche superficielle (21,12) présente une épaisseur inférieure ou égale à 1µm, typiquement de l'ordre de cent à quelques centaines de nanomètres.

6. Procédé de fabrication selon l'une des revendications précédentes, dans lequel l'étape c) comprend le dépôt d'une couche en carbure de silicium amorphe, au moins du côté de la face avant (20a) du substrat support (20) et/ou au moins sur la couche poreuse (11), pour former la (ou les) couche(s) superficielle(s) (21,12).

7. Procédé de fabrication selon la revendication précédente, dans lequel la couche en carbure de silicium amorphe déposée est fortement dopée et présente une concentration en espèces dopantes supérieure à 10¹⁹/cm³, voire supérieure à 10²⁰/cm³.

8. Procédé de fabrication selon l'une des revendications 1 à 5, dans lequel l'étape c) comprend une amorphisation d'une couche de surface du substrat support (20), au moins du côté de sa face avant (20a), pour former la couche superficielle (21).

9. Procédé de fabrication selon l'une des revendications précédentes, dans lequel l'étape d) comprend, préalablement à l'assemblage du substrat initial (10) et du substrat support (20), la formation d'une couche de collage sur l'un et/ou l'autre des substrats, du côté de leurs faces avant respectives,
la couche de collage présentant, après assemblage, une épaisseur totale inférieure ou égale à 10nm.

10. Procédé de fabrication selon la revendication précédente, dans lequel la couche de collage est composée d'au moins un matériau choisi parmi le silicium, le nickel, le titane et le tungstène.

11. Procédé de fabrication selon l'une des deux revendications précédentes, dans lequel, au cours de l'étape e), une segmentation sous forme de nodule ou une dissolution de la couche de collage autorise un contact direct, au moins localement, entre la couche superficielle (21) et la couche poreuse (11) ou entre la couche superficielle (12) et le substrat support (20).

12. Procédé de fabrication selon l'une des revendications précédentes, dans lequel, le traitement thermique de l'étape e) est effectué à une température supérieure ou égale à 1000°C, préférentiellement supérieure ou égale à 1400°C, voire supérieure ou égale à 1850°C.

13. Procédé de fabrication selon l'une des revendications précédentes, dans lequel, à l'étape e), la cristallisation de la couche superficielle (21,12) s'opère au moins en partie sous forme de carbure de silicium poly-cristallin, à partir d'une interface de contact avec le substrat support (20), pour former une couche intermédiaire (22).

14. Procédé de fabrication selon l'une des revendications précédentes, comprenant, après l'étape f), une étape g) de finition comprenant des traitement(s) mécanique(s) et/ou chimique(s) de la structure composite (100), pour éliminer des résidus (11r) de couche poreuse (11) de la face avant (1a) de la couche mince (1) et/ou pour corriger l'uniformité d'épaisseur de la structure composite (100).

15. Procédé de fabrication selon la revendication précédente, dans lequel l'étape g) comprend un traitement thermique, appliqué à la structure composite (100), à une température comprise entre 1000°C et 1900°C, avant ou après les traitements mécanique(s) et/ou chimique(s).

16. Procédé de fabrication selon l'une des revendications précédentes, comprenant une étape de reconditionnement du reste (10') du substrat initial en vue d'une réutilisation en tant que substrat initial (10) pour la fabrication d'une nouvelle structure composite (100).

17. Structure intermédiaire (30,30') comprenant :
- un substrat support (20) en carbure de silicium poly-cristallin,
- au moins une couche superficielle (21,12) en carbure de silicium amorphe, disposée sur le substrat support (20), du côté de sa face avant (20a),
- une couche poreuse (11) disposée sur la couche superficielle (21,12),
- un substrat initial (10) en carbure de silicium monocristallin sur la couche poreuse (11)
la couche poreuse (11) étant disposée directement en contact ou via une couche de collage sur la couche superficielle (21), une interface de collage (3) étant présente entre la couche poreuse (11) et la couche superficielle (21), ou la couche superficielle (12) étant disposée directement en contact ou via une couche de collage, sur le substrat support (20), une interface de collage (3') étant présente entre le substrat support (20) et la couche superficielle (12), ou
une couche superficielle (12) du côté de la couche poreuse (11) étant disposée directement en contact ou via une couche de collage sur une autre couche superficielle (21) du côté du substrat support (20), une interface de collage (3") étant présente entre les deux couches superficielles (21, 12) .

## Patentansprüche

1. Verfahren zum Herstellen einer Verbundstruktur (100), umfassend eine dünne Schicht (1) aus monokristallinem Siliciumcarbid, die auf einem Trägersubstrat (20) aus polykristallinem Siliciumcarbid angeordnet ist, das Verfahren umfassend:
**a)** einen Schritt eines Bereitstellens eines Ausgangssubstrats (10) aus monokristallinem Siliciumcarbid, das eine Vorderseite (10a) und eine Rückseite (10b) aufweist, und eines Trägersubstrats (20) aus polykristallinem Siliciumcarbid, das eine Vorderseite (20a) und eine Rückseite (20b) aufweist,
**b)** einen Porosierungsschritt, der auf das Ausgangssubstrat (1) angewendet wird, zum Ausbilden mindestens einer porösen Schicht (11) auf mindestens der Seite der Vorderseite (10a) des Ausgangssubstrats (10),
**c)** einen Schritt zum Ausbilden einer Oberflächenschicht (21, 12) aus amorphem Siliciumcarbid auf der Vorderseite (20a) des Trägersubstrats (20) und/oder auf der porösen Schicht (11),
**d)** einen Schritt eines Zusammenfügens des Ausgangssubstrats (10) und des Trägersubstrats (20) an ihren jeweiligen Vorderseiten, was zu der Gewinnung einer ersten Zwischenstruktur (30, 30', 30") führt,
**e)** einen Wärmebehandlungsschritt, der auf die erste Zwischenstruktur (30, 30', 30") angewendet wird, bei einer Temperatur über 900 °C , zum Kristallisieren der Oberflächenschicht (21, 12) mindestens teilweise in Form von monokristallinem Siliciumcarbid aus einer Kontaktschnittstelle mit der porösen Schicht (11) zum Ausbilden der dünnen Schicht (1), wobei Schritt e) zu der Gewinnung einer zweiten Zwischenstruktur (40) führt,
**f)** einen Abscheidungsschritt in der porösen Schicht (11) der zweiten Zwischenstruktur (40), zum Gewinnen einerseits der Verbundstruktur (100) und andererseits des Rests (10') des Ausgangssubstrats.

2. Herstellungsverfahren nach dem vorstehenden Anspruch, wobei die poröse Schicht (11) am Ende von Schritt b) eine Dicke zwischen 0,5 µm und 5 µm aufweist.

3. Herstellungsverfahren nach einem der vorstehenden Ansprüche, wobei die poröse Schicht (11) am Ende von Schritt b) Poren umfasst, deren Größe zwischen 1 nm und 50 nm liegt, und einen Porosierungsgrad zwischen 10 % und 70 % aufweist.

4. Herstellungsverfahren nach einem der vorstehenden Ansprüche, wobei am Ende von Schritt c) die Oberflächenschicht (21,12) eine Dicke kleiner als oder gleich 10 µm aufweist.

5. Herstellungsverfahren nach einem der vorstehenden Ansprüche, wobei die Oberflächenschicht (21, 12) am Ende von Schritt c) eine Dicke von kleiner oder gleich 1 µm, typischerweise in der Größenordnung von einhundert bis einigen hundert Nanometern, aufweist.

6. Herstellungsverfahren nach einem der vorstehenden Ansprüche, wobei Schritt c) das Abscheiden einer Schicht aus amorphem Siliciumcarbid mindestens auf der Seite der Vorderseite (20a) des Trägersubstrats (20) und/oder mindestens auf der porösen Schicht (11) zum Ausbilden der Oberflächenschicht(en) (21, 12) umfasst.

7. Herstellungsverfahren nach dem vorstehenden Anspruch, wobei die abgeschiedene amorphe Siliciumcarbidschicht stark dotiert ist und eine Konzentration an Dotierungsarten von mehr als 10¹⁹/cm³ oder sogar mehr als 10²⁰/cm³ aufweist.

8. Herstellungsverfahren nach einem der Ansprüche 1 bis 5, wobei Schritt c) eine Amorphisierung einer Oberflächenschicht des Trägersubstrats (20) mindestens auf der Seite seiner Vorderseite (20a) zum Ausbilden der Oberflächenschicht (21) umfasst.

9. Herstellungsverfahren nach einem der vorstehenden Ansprüche, wobei Schritt d) vor dem Zusammenfügen des Ausgangssubstrats (10) und des Trägersubstrats (20) die Ausbildung einer Klebeschicht auf dem einen und/oder dem anderen Substrat auf der Seite ihrer jeweiligen Vorderseiten umfasst,
wobei die Klebeschicht nach dem Zusammenfügen eine Gesamtdicke von weniger als oder gleich 10 nm aufweist.

10. Herstellungsverfahren nach dem vorstehenden Anspruch, wobei die Klebeschicht aus mindestens einem Material besteht, das aus Silizium, Nickel, Titan und Wolfram ausgewählt ist.

11. Herstellungsverfahren nach einem der zwei vorstehenden Ansprüche, wobei während Schritt e) eine knotenförmige Segmentierung oder eine Auflösung der Klebeschicht mindestens lokal einen direkten Kontakt zwischen der Oberflächenschicht (21) und der porösen Schicht (11) oder zwischen der Oberflächenschicht (12) und dem Trägersubstrat (20) zulässt.

12. Herstellungsverfahren nach einem der vorstehenden Ansprüche, wobei die Wärmebehandlung von Schritt e) bei einer Temperatur größer als oder gleich 1000 °C, vorzugsweise größer als oder gleich 1400 °C oder sogar größer oder gleich 1850 °C durchgeführt wird.

13. Herstellungsverfahren nach einem der vorstehenden Ansprüche, wobei in dem Schritt e) die Kristallisation der Oberflächenschicht (21, 12) mindestens teilweise in Form von polykristallinem Siliciumcarbid aus einer Kontaktschnittfläche mit dem Trägersubstrat (20) zum Ausbilden einer Zwischenschicht (22) erfolgt.

14. Herstellungsverfahren nach einem der vorstehenden Ansprüche, umfassend nach Schritt f) einen Endbearbeitungsschritt g), umfassend (eine) mechanische und/oder chemische Behandlung(en) der Verbundstruktur (100) zum Entfernen von Resten (11r) der porösen Schicht (11) von der Vorderseite (1a) der dünnen Schicht (1) und/oder Korrigieren der Dickengleichmäßigkeit der Verbundstruktur (100).

15. Herstellungsverfahren nach dem vorstehenden Anspruch, wobei Schritt g) eine Wärmebehandlung der Verbundstruktur (100) bei einer Temperatur zwischen 1000 °C und 1900 °C vor oder nach den mechanischen und/oder chemischen Behandlungen umfasst.

16. Herstellungsverfahren nach einem der vorstehenden Ansprüche, umfassend einen Schritt eines Wiederaufbereitens des Rests (10') des Ausgangssubstrats im Hinblick auf eine Wiederverwendung in der Eigenschaft als Ausgangssubstrat (10) für die Herstellung einer neuen Verbundstruktur (100).

17. Zwischenstruktur (30, 30') umfassend:
- ein Trägersubstrat (20) aus polykristallinem Siliciumcarbid,
- mindestens eine Oberflächenschicht (21, 12) aus amorphem Siliciumcarbid, die auf dem Trägersubstrat (20) auf der Seite seiner Vorderseite (20a) angeordnet ist,
- eine poröse Schicht (11), die auf der Oberflächenschicht (21,12) angeordnet ist,
- ein Ausgangssubstrat (10) aus monokristallinem Siliciumcarbid auf der porösen Schicht (11)
wobei die poröse Schicht (11) direkt in Kontakt oder über eine Klebeschicht auf der Oberflächenschicht (21) angeordnet ist, wobei eine Verbindungsschnittfläche (3) zwischen der porösen Schicht (11) und der Oberflächenschicht (21) vorhanden ist, oder die Oberflächenschicht (12) direkt in Kontakt oder über eine Klebeschicht auf dem Trägersubstrat (20) angeordnet ist, wobei zwischen dem Trägersubstrat (20) und der Oberflächenschicht (12) eine Verbindungsschnittfläche (3') vorhanden ist, oder
wobei eine Oberflächenschicht (12) auf der Seite der porösen Schicht (11) direkt in Kontakt oder über eine Klebeschicht auf einer anderen Oberflächenschicht (21) auf der Seite des Trägersubstrats (20) angeordnet ist, wobei zwischen den zwei Oberflächenschichten (21, 12) eine Verbindungsschnittfläche (3") vorhanden ist.

## Claims

1. Method for producing a composite structure (100) comprising a thin layer (1) made of monocrystalline silicon carbide arranged on a support substrate (20) made of polycrystalline silicon carbide, the method comprising:
a) a step of providing an initial substrate (10) made of monocrystalline silicon carbide having a front face (10a) and a rear face (10b), and a support substrate (20) made of polycrystalline silicon carbide having a front face (20a) and a rear face (20b),
b) a porosification step applied to the initial substrate (1), to form a porous layer (11) at least on the front face (10a) of the initial substrate (10),
c) a step of forming a surface layer (21, 12) made of amorphous silicon carbide on the front face (20a) of the support substrate (20) and/or on the porous layer (11),
d) a step of joining the initial substrate (10) and the support substrate (20) at their respective front faces, resulting in obtaining a first intermediate structure (30, 30', 30"),
e) a heat treatment step applied to the first intermediate structure (30, 30', 30"), at a temperature greater than 900°C, in order to crystallize the surface layer (21, 12) at least partially in the form of monocrystalline silicon carbide, from a contact interface with the porous layer (11), to form the thin layer (1), step e) resulting in obtaining a second intermediate structure (40),
f) a separation step in the porous layer (11) of the second intermediate structure (40), to obtain both the composite structure (100) and the remainder (10') of the initial substrate.

2. Production method according to the preceding claim, wherein, at the end of step b), the porous layer (11) has a thickness of between 0.5µm and 5µm.

3. Production method according to one of the preceding claims, wherein, at the end of step b), the porous layer (11) comprises pores, the size of which is between 1nm and 50nm, and has a level of porosification of between 10% and 70%.

4. Production method according to one of the preceding claims, wherein, at the end of step c), the surface layer (21, 12) has a thickness of less than or equal to 10µm.

5. Production method according to one of the preceding claims, wherein, at the end of step c), the surface layer (21, 12) has a thickness of less than or equal to 1µm, typically in the range of one hundred to a few hundred nanometers.

6. Production method according to one of the preceding claims, wherein step c) comprises depositing a layer of amorphous silicon carbide, at least on the front face (20a) of the support substrate (20) and/or at least on the porous layer (11), to form the surface layer(s) (21, 12).

7. Production method according to the preceding claim, wherein the deposited amorphous silicon carbide layer is highly doped and has a concentration of dopant species greater than 10¹⁹/cm³, or greater than 10²⁰/cm³.

8. Production method according to one of claims 1 to 5, wherein step c) comprises amorphization of a superficial layer of the support substrate (20), at least on its front face (20a), to form the surface layer (21).

9. Production method according to one of the preceding claims, wherein step d) comprises, prior to the joining of the initial substrate (10) and the support substrate (20), forming a bonding layer on one and/or the other of the substrates, on their respective front faces,
the bonding layer having, after joining, a total thickness of less than or equal to 10nm.

10. Production method according to the preceding claim, wherein the bonding layer is composed of at least one material selected from silicon, nickel, titanium and tungsten.

11. Production method according to one of the two preceding claims, wherein, in step e), nodular segmentation or dissolution of the bonding layer enables direct contact, at least locally, between the surface layer (21) and the porous layer (11) or between the surface layer (12) and the support substrate (20).

12. Production method according to one of the preceding claims, wherein the heat treatment in step e) is carried out at a temperature greater than or equal to 1000°C, preferably greater than or equal to 1400°C, or greater than or equal to 1850°C.

13. Production method according to one of the preceding claims, wherein, in step e), crystallization of the surface layer (21, 12) occurs at least partially in the form of polycrystalline silicon carbide, from a contact interface with the support substrate (20), to form an intermediate layer (22).

14. Production method according to one of the preceding claims, comprising, after step f), a finishing step g) comprising mechanical and/or chemical treatment(s) of the composite structure (100), for removing residues (11r) of the porous layer (11) from the front face (1a) of the thin layer (1) and/or for correcting the thickness uniformity of the composite structure (100).

15. Production method according to the preceding claim, wherein step g) comprises a heat treatment applied to the composite structure (100) at a temperature of between 1000°C and 1900°C, before or after the mechanical and/or chemical treatment(s).

16. Production method according to one of the preceding claims, comprising a step of reprocessing the remainder (10') of the initial substrate for reuse as an initial substrate (10) for producing a new composite structure (100).

17. Intermediate structure (30, 30') comprising:
- a support substrate (20) made of polycrystalline silicon carbide,
- at least one surface layer (21, 12) made of amorphous silicon carbide, arranged on the front face (20a) of the support substrate (20),
- a porous layer (11) arranged on the surface layer (21, 12),
- an initial substrate (10) made of monocrystalline silicon carbide on the porous layer (11)
the porous layer (11) being arranged, directly in contact or via a bonding layer, on the surface layer (21), a bonding interface (3) being present between the porous layer (11) and the surface layer (21), or the surface layer (12) being arranged, directly in contact or via a bonding layer, on the support substrate (20), a bonding interface (3') being present between the support substrate (20) and the surface layer (12), or
a surface layer (12) on the porous layer (11) being arranged, directly in contact or via a bonding layer, on another surface layer (21) on the support substrate (20), a bonding interface (3") being present between the two surface layers (21, 12).
